Europäisches Patentamt

European Patent Office

Office européen des brevets

(11) Publication number: **0 165 766**
**B1**

## EUROPEAN PATENT SPECIFICATION

(45) Date of publication of patent specification: **30.08.89**

(21) Application number: **85304174.7**

(22) Date of filing: **12.06.85**

(51) Int. Cl.⁴: **H 01 L 27/06,** H 03 H 11/12

(54) Integrated circuit filter.

(30) Priority: **20.06.84 US 622414**

(43) Date of publication of application:
**27.12.85 Bulletin 85/52**

(45) Publication of the grant of the patent:
**30.08.89 Bulletin 89/35**

(84) Designated Contracting States:
**DE FR GB NL**

(56) References cited:
**EP-A-0 014 310**
**GB-A-2 077 496**

**IBM TECHNICAL DISCLOSURE BULLETIN, vol.
23, no. 3, August 1980, page 1058, New York,
US; J.K. HOWARD: "Dual dielectric capacitor"**

(73) Proprietor: **AMERICAN MICROSYSTEMS,
INCORPORATED**
**3800 Homestead Road**
**Santa Clara, CA 95051 (US)**

(72) Inventor: **Haque, Yusuf A.**
**2052 Laddie Way**
**San Jose California 95121 (US)**

(74) Representative: **Ackroyd, Robert et al**
**POLLAK MERCER & TENCH High Holborn House**
**52-54 High Holborn**
**London WC1V 6RY (GB)**

Courier Press, Leamington Spa, England.

# EP 0 165 766 B1

**Description**

This invention relates to the design and structure of electronic filters, and more particularly to an electronic filter which can be implemented in an integrated circuit having a substantially reduced die area as compared with prior art filters.

Filters are well known in the prior art. Such filters serve as means for rejecting signals above a selected frequency (low pass filter), rejecting signals below a selected frequency (high pass filter), rejecting signals of a selected frequency (notch filter), or rejecting frequencies other than those within a predefined frequency range (band pass filter). Oftentimes, it is desirable to sample an analog signal; for example, for use in a sampled data system. Such sampled data systems are widespread and provide the advantages of allowing a digital circuit to perform analog functions. One of the problems associated with such sampled systems is known as "aliasing". Aliasing is the undesired effect that, in addition to passing selected frequencies within its desired pass band, a sampled data system will pass signals having a frequency near the sampling frequency.

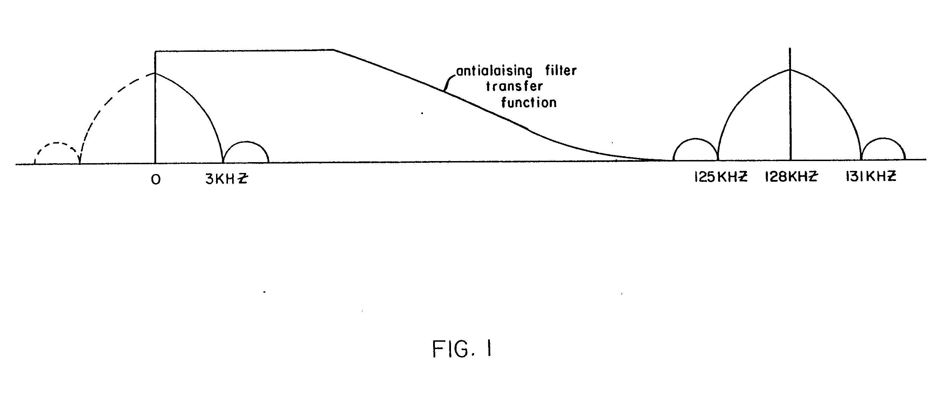

Figure 1 illustrates this aspect of aliasing. Fig. 1 shows a frequency domain graph of a sampled data system in which it is desired to pass audio signals within the frequency range of 0—3 kHz. Thus, the filter characteristics are such as are shown on the left-hand side of Fig. 1. However, when the sampled data rate is 128 kHz, the same transfer function is provided on both sides of 128 kHz. Thus, signals within the range of 128±3 kHz are passed by the sampled data system. Further, these signals appear at the base band by virtue of being "mixed" with the 128 kHz clock frequency. It is therefore desirable to eliminate the presence of such high frequency signals prior to being fed to the sampled data system. In this manner, although the sampled data system will have little or no attenuation of 125—131 kHz signals, such signals will not be present in the input signal provided to the sampled data system, and thus are removed from the filter output. In order to accomplish this, oftentimes a low pass prefilter, or "antialiasing filter", is utilized to filter out such high frequency components of the input signal prior to applying the filtered input signal to the sampled data system. The graph of the transfer function of a typical antialiasing filter is shown superimposed on the graph of Fig. 1.

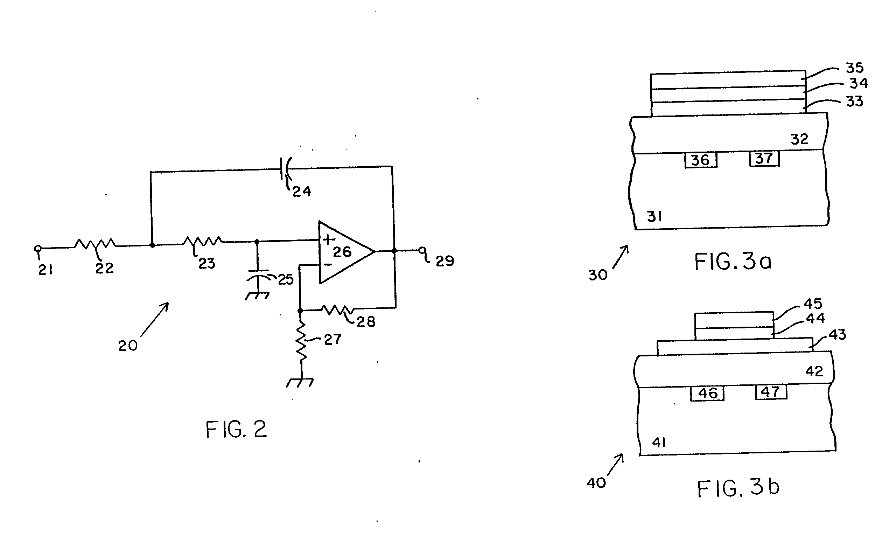

Such antialiasing filters are well known in the prior art and typically comprise a simple low pass filter. In many instances, a fair amount of attenuation is desired, and thus a two-pole filter is utilized. One such two-pole filter is shown in the schematic diagram of Figure 2. Antialiasing filter 20 includes operational amplifier 26 having its inverting input terminal connected through resistor 27 to ground and also through resistor 28 to output terminal 29. The noninverting input terminal of operational amplifier 26 is connected through capacitor 25 to ground and through resistor 23 and resistor 22 to input terminal 21. The node between resistors 22 and 23 is connected through capacitor 24 to the output terminal of operational amplifier 26. The transfer function for the two-pole low pass filter 20 is as follows:

$$H(s) = \frac{V_{out}(s)}{V_{in}(s)} = G_1 \, b_0/(s^2 + b_1 \, s + b_0),$$

where

$$b_0 = 1/(R_{22} \, R_{23} \, C_{24} \, C_{25})$$

$$b_1 = [(1 - G_1)/(R_{23} \, C_{25})] + 1/(R_{22} \, C_{24}) + 1/(R_{23} \, C_{24})$$

$$G_1 = 1 + R_{28}/R_{27}$$

where

$H(s)$=the transfer function of antialiasing filter 20;
$R_{22}$=the resistance of resistor 22;
$R_{23}$=the resistance of resistor 23;
$R_{27}$=the resistance of resistor 27;
$R_{28}$=the resistance of resistor 28;
$C_{24}$=the capacitance of capacitor 24;
$C_{25}$=the capacitance of capacitor 25; and
$G_1$=the closed loop gain of operational amplifier 26.

In practice, the values of resistors 22, 23, 27 and 28 and capacitors 24 and 25 are selected by well-known principles, such as are stated in "Rapid Practical Design of Active Filters" by D. E. Johnson and J. L. Hilburn, John Wiley & Son, (particularly pages 12, 13 and 27—29), which is hereby incorporated by reference.

Oftentimes, it is desired to fabricate an entire sampled data system as a single integrated circuit device. In this case, it is possible to provide an antialiasing filter as shown in Fig. 2 external to the integrated circuit, although this is undesirable. Therefore, it is desirable to fabricate the sampled data system, together with one or more antialiasing filters such as the antialiasing filter 20 of Fig. 2, as part of the same integrated circuit. While this has been done, the fabrication of such antialiasing filter 20 in Fig. 2 on an integrated

2

circuit requires a considerable amount of die area, particularly when it is recognized that oftentimes a single sampled data integrated circuit requires four or more such antialiasing filters to be fabricated on the single integrated circuit chip. Prior art techniques for fabricating such antialiasing filters utilize portions of the polycrystalline silicon interconnect layer as resistors 22, 23, 27 and 28. While the use of polycrystalline silicon resistors is well known, and easily implemented in order to fabricate the antialiasing filter 20 of Fig. 2, the use of polycrystalline silicon resistors requires a substantial amount of die area. Polycrystalline silicon resistors typically have a resistance of approximately 20 ohms per square. Typically resistor values needed are within the range of approximately 50 kΩ to 400 kΩ. Using polycrystalline silicon requires a large number of squares (for example, 1 square of polycrystalline silicon may be designed to be 8 microns square); further, resistors are spaced at least 5 microns apart and thus require a large area. Table 1 shows an approximate area calculation for a voice band filter having a closed loop gain of unity. Thus, the prior art antialiasing filter 20 of Fig. 2, fabricated on an integrated circuit device utilizing prior art techniques including the use of polycrystalline silicon resistors, and allowing approximately 10% additional area for proper spacing and interconnection, requires approximately 1730 sq. mils per antialiasing filter. This is a substantial amount of integrated circuit device area, and substantially limits the number of integrated circuits which may be formed on a single semiconductor wafer. As is well known, the smaller the die area required for an integrated circuit, the more integrated circuits may be fit onto a single semiconductor wafer, and the greater number of finished integrated circuits possible for a given amount of semiconductor processing. This, of course, decreases the cost of each finished integrated circuit device.

A semiconductor element having a substrate with a channel zone which may act as a resistor with distributed capacitance to an overlying gate electrode and to the substrate is described in GB—A— 2077 496. Another semiconductor device, described in JP—A—56-133863, has a resistor in a substrate over which is provided polycrystalline silicon.

According to one aspect of this invention there is provided a semiconductor structure including a substrate of a first conductivity type, a resistor formed within the substrate, the resistor being lightly doped to a second conductivity type opposite to the first conductivity type and a first conductive plate formed above and insulated from the resistor, wherein the first conductive plate is intended for coupling to a fixed voltage to shield the underlying resistor, characterised by a second conductive plate formed above and insulated from the first conductive plate, the first and second conductive plates forming a capacitor.

According to a second aspect of the invention there is provided a method for forming a semiconductor structure including the steps of forming within a semiconductor substrate of a first conductivity type a resistor being lightly doped to a second conductivity type opposite to the first conductivity type, forming a first insulation layer over the semiconductor substrate, and forming a first conductive plate on the first insulation layer above the resistor, wherein the first conductive plate is intended for coupling to a fixed voltage to shield the underlying resistor, characterised by including the steps of forming a second insulation layer on the first conductive plate and forming a second conductive plate on the second insulation layer.

According to a third aspect of the invention there is provided an integrated circuit filter in a semiconductor body including an operation amplifier, a capacitor, and a resistor, wherein the resistor is formed as a lightly doped region within the semiconductor body and the capacitor is formed by a first conductive plate and a second conductive plate wherein the first conductive plate is formed above and insulated from the resistor so that when a fixed voltage is coupled to the first conductive plate the plate will shield the underlying resistor, characterised in that the second conductive plate is formed above and insulated from the first conductive plate.

Highly preferred features of the invention are given in the dependent claims.

In accordance with the teachings of this invention, an electronic filter is provided which has particular application for use as an antialiasing filter in sampled data systems. The filter of this invention is fabricated so as to utilize high resistivity diffused regions within the semiconductor body, as opposed to low resistivity polycrystalline silicon resistors. In this invention the values of the resistor and capacitor will be such that the high resistivity resistor requires a small amount of space, and is physically located under the lower plate of the capacitor used in the filter of this invention. In accordance with the teachings of this invention, the lower plate of the capacitor is intended to be connected to a fixed voltage potential, thereby in effect shielding the underlying resistor from the deleterious effect of changes in voltage, and thus preventing the modulation of the resistance value of the resistors located beneath the capacitor. In this manner, the resistance value is highly constant.

The invention will be described further by way of example with reference to Figures 3a and 3b of the drawings. Of these:

Figure 3a is a cross-sectional view of the resistors and capacitors formed in accordance with the teachings of this invention in order to fabricate a filter in accordance with the teachings of this invention; and

Figure 3b is a cross-sectional view of another embodiment of the resistors and capacitors utilized in accordance with the teachings of this invention.

In accordance with the teachings of this invention, a filter is designed in such a manner that the resistors required are fabricated of relatively high resistivity diffused areas within a semiconductor body, rather than the relatively low resistivity polycrystalline silicon resistors utilized in the prior art or relatively low resistivity diffused resistors utilized in the prior art. For example, polycrystalline silicon resistors typically have a resistance of approximately 20 ohms per square, which is significantly less than the resistivity of the high resistivity diffused regions utilized as resistors in accordance with the teachings of this invention, which have resistivities of approximately 2000 ohms per square. Accordingly, the use of such higher resistivity resistors allows an integrated circuit areas savings for the formation of resistors of approximately 100-fold.

While the use of this invention contemplates the fabrication of resistors of diffused regions having relatively high resistivities within a semiconductor body, it is also contemplated that this may be accomplished without the need for additional masking or doping steps. For example, in standard CMOS processing technology, well regions are formed having relatively high resistivites. By suitable masking techniques, the high resistivity resistors fabricated in accordance with the teachings of this invention are fabricated simultaneously with the fabrication of such well regions, thereby not requiring any additional masking or doping steps.

Also, in accordance with the teachings of this invention, the resistance values themselves and the capacitance values are selected such that the resistors may be located in the area beneath the capacitors. In this manner, since there are generally no active devices formed beneath the capacitors formed on an integrated circuit, a significant saving in die area is achieved. Referring to Fig. 3a, the cross-sectional view of a portion of an integrated circuit including resistor diffusions 36 and 37 is shown beneath the capacitor formed of plates 33 and 35 and interplate dielectric layer 34. Resistors 36 and 37 are insulated from plate 33 by insulation layer 32, which in one embodiment is field oxide having a thickness on the order of 10,000 Å. Not shown in Figure 3a are small portions of resistor diffusions 36 and 37 which are used to provide electrical interconnection to resistor diffusions 36 and 37. These portions of rseistor diffusions 36 and 37 can, if desired, extend out from beneath capacitor plate 33 to provide easy electrical connection to other circuit elements (not shown).

In accordance with the teachings of this invention, the lower plate 33 is connected to ground (or any other suitable constant voltage) in order to effectively shield the resistance diffusions 36 and 37 from the undesirable effect of changing voltage levels. As is well known to those of ordinary skill in the art, the resistance of a lightly doped diffused region varies depending upon the voltages impressed upon it. In this manner, by utilizing the lower plate 33 as a reference plate, diffused resistance regions 36 and 37 are not influenced by various voltages in the integrated circuit device, and thus exhibit highly constant resistance values. This is particularly important because, if the resistor values are not constant, their resistance values are not linear with voltage and current, they may serve as multipliers and in effect provide harmonics of the signals passing through them. Thus, in one embodiment of this invention, the lower plate 33 of the capacitor shown in Fig. 3a corresponds to the lower plate of capacitor 25 shown in Figure 2, which is connected to ground.

As has been previously described, it is desired that the resistance and capacitance values of the filter be selected such that the resistors may be fabricated beneath the capacitors and, preferably, that the resistors be fabricated beneath only those capacitors in the filter having their lower plate connected to ground or a fixed voltage level. However, in the event that this is not feasible, it is a further teaching of this invention that the lower plate be expanded in area in order to cover the underlying resistors. This is depicted in Fig. 3b in which the lower plate 43 of the capacitor, which is connected to ground or a suitable reference voltage, is significantly larger than the upper plate 45. While the added area of lower plate 43 has minimal effect on the capacitance value of the capacitor, it has great effect in shielding the underlying resistors.

It is believed that the fact that the underlying resistors are shielded by a top plate tied to a fixed voltage supply provides greater stability of the resistance values than would locating the resistors beneath an unused portion of the integrated circuit. In effect, the shielding properties of the lower plate of the capacitor serves to suppress any stray induced voltages on the underlying resistors. Therefore, in accordance with the teachings of this invention, a plate having a substantially fixed voltage impressed thereon is formed over and insulated from underlying diffused resistors in order to shield those resistors from spurious voltages created in other parts of the circuit.

In accordance with the teachings of this invention, the low pass antialiasing filter of Fig. 2 was constructed having substantially the same transfer characteristic as in the prior art example set out in Table 1. However, the resistance values of resistors 22, 23, 27 and 28 were selected such that they conveniently are located beneath the lower plate of capacitor 25. In this embodiment of the low pass antialiasing filter constructed in accordance with our invention, the resistance and capacitance values and sizes are given as shown below in Table 2, where the resistances of resistors 27 and 28 are selected such that the closed loop gain of operational amplifier 26 is unity. The resistance and capacitance values and sizes in an alternative embodiment of this invention, where the resistances of resistors 27 and 28 are selected such that the closed loop gain of operational amplifier 26 is equal to four, is shown in Table 3.

As shown by the results given in Tables 2 and 3, filters fabricated in accordance with the teachings of this invention are fabricated utilizing significantly less integrated circuit die area than comparable filters constructed in accordance with prior art techniques.

It will be appreciated that, when making a diffused resistor, doping is used which is light relative to that used in other types of semiconductor device in order to make efficient use of semiconductor area. Thus, in the claims of this application, the term "lightly doped" refers to a semiconductor region which is doped to an extent which is appropriate for the formation of a diffused resistor and is low relative to the doping levels of doped regions commonly used in other types of semiconductor devices.

TABLE 1

| Component | Approximate value | Approximate integrated circuit area |
|---|---|---|
| Resistor 22 | 60 kΩ | 312,000 square microns |
| Resistor 23 | 60 kΩ | 312,000 square microns |
| Resistor 27 | ∞ | 0 |
| Resistor 28 | 0 | 0 |
| Capacitor 24 | 68.6 pF | 137,104 square microns |
| Capacitor 25 | 34.3 pF | 68,552 square microns |
| Oper. Amp. 26 | | 154,000 square microns |
| Total | | 983,656 square microns= 1,574 square mils |

This does not include approximately 10% additional area required for electrical interconnection and proper spacing between components.

TABLE 2

| Component | Approximate value | Approximate integrated circuit area |
|---|---|---|
| Resistor 22 | 146 kΩ | 18,700 square microns |
| Resistor 23 | 262 kΩ | 36,000 square microns |
| Resistor 27 | ∞ | 0 |
| Resistor 28 | 0 | 0 |
| Capacitor 24 | 71.4 pF | 142,850 square microns |
| Capacitor 25 | 23.6 pF | 47,140 square microns |
| Oper. Amp. 26 | | 154,000 square microns |
| Total | | 398,690 square microns= 638 square mils |
| OR, by placing resistors 22, 23, 27 and 28 beneath capacitor 25 | | 343,990 square microns= 550 square mils |

This does not include approximately 10% additional area required for electrical interconnection and proper spacing between components.

TABLE 3

| Component | Approximate value | Approximate integrated circuit area |
|---|---|---|
| Resistor 22 | 158 kΩ | 20,000 square microns |
| Resistor 23 | 385 kΩ | 50,000 square microns |
| Resistor 27 | 15 kΩ | 1,900 square microns |
| Resistor 28 | 60 kΩ | 7,600 square microns |
| Capacitor 24 | 23.8 pF | 47,637 square microns |
| Capacitor 25 | 47.6 pF | 95,274 square microns |
| Oper. Amp. 26 | | 154,000 square microns |
| Total | | 376,411 square microns= 602 square mils |
| OR, by placing resistors 22, 23, 27 and 28 beneath capacitor 25 | | 296,911 square microns= 475 square mils |

This does not include approximately 10% additional area required for electrical interconnection and proper spacing between components.

**Claims**

1. A semiconductor structure (30; 40) including a substrate (31; 41) of a first conductivity type, a resistor (36, 37; 46, 47) formed within the substrate, the resistor being lightly doped to a second conductivity type opposite to the first conductivity type and a first conductive plate (33; 43) formed above and insulated from the resistor, wherein the first conductive plate is intended for coupling to a fixed voltage to shield the underlying resistor, characterised by a second conductive plate (35; 45) formed above and insulated from the first conductive plate, the first and second conductive plates forming a capacitor.

2. A structure as claimed in claim 1, characterised in that the first conductive plate (43) has a larger area than said second conductive plate (45).

3. A method for forming a semiconductor structure (30; 40), including the steps of forming within a semiconductor substrate (31; 41) of a first conductivity type a resistor (36, 37; 46, 47) being lightly doped to a second conductivity type opposite to the first conductivity type, forming a first insulation layer (32; 42) over the semiconductor substrate, and forming a first conductive plate (33; 43) on the first insulation layer above the resistor, wherein the first conductive plate is intended for coupling to a fixed voltage to shield the underlying resistor, characterised by including the steps of forming a second insulation layer (34; 44) on the first conductive plate and forming a second conductive plate (35; 45) on the second insulation layer.

4. A method as claimed in claim 3, characterised in that the second conductive plate (45) is formed to have a lesser area than the first conductive plate (43).

5. An integrated circuit filter in a semiconductor body including an operation amplifier, a capacitor, and a resistor, wherein the resistor is formed as a lightly doped region (36, 37; 46, 47) within the semiconductor body (31; 41), and the capacitor is formed by a first conductive plate (33; 43) and a second conductive plate (35; 45), wherein the first conductive plate is formed above and insulated from the resistor so that when a fixed voltage is coupled to the first conductive plate the plate will shield the underlying resistor, characterised in that the second conductive plate is formed above and insulated from the first conductive plate.

6. A filter as claimed in claim 5, characterised in that the first conductive plate (43) has an area greater than the area of the second conductive plate (45).

**Patentansprüche**

1. Halbleiterstruktur (30; 40), enthaltend ein Substrat (31; 41) eines ersten Leitfähigkeitstyps, einen im Substrat gebildeten Widerstand (36, 37; 46, 47), wobei der Widerstand zu einem zweiten Leitfähigkeitstyp entgegengesetzt zum ersten Leitfähigkeitstyp leicht dotiert ist, und eine erste leitende Platte (33; 43), die oberhalb des Widerstandes und von diesem isoliert gebildet ist, wobei die erste leitende Platte zum Koppeln mit einer festen Spannung bestimmt ist, um den darunter liegenden Widerstand abzuschirmen, gekennzeichnet durch eine zweite leitende Platte (35; 45), die oberhalb der ersten leitenden Platte gebildet und von dieser isoliert ist, wobei die erste und zweite leitende Platte einen Kondensator bilden.

2. Struktur nach Anspruch 1, dadurch gekennzeichnet, daß die erste leitende Platte (43) eine größere Fläche als die zweite leitende Platte (45) hat.

3. Verfahren zur Bildung einer Halbleiterstruktur (30; 40), enthaltend die Schritte, daß in einem Halbleitersubstrat (31, 41) eines ersten Leitfähigkeitstyps ein Widerstand (36, 37; 46, 47) gebildet wird, der zu einem zweiten Leitfähigkeitstyp entgegengesetzt zum ersten Leitfähigkeitstyp leicht dotiert ist, eine erste Isolationsschicht (32; 42) über dem Halbleitersubstrat gebildet wird und eine erste leitende Platte (33; 43) auf der ersten Isolationsschicht oberhalb des Widerstandes gebildet wird, wobei die erste leitende Platte zur Kopplung mit einer festen Spannung bestimmt ist, um den darunter liegenden Widerstand abzuschirmen, dadurch gekennzeichnet, daß die Schritte enthalten sind, daß eine zweite Isolationsschicht (34, 44) auf der ersten leitenden Platte gebildet wird und eine zweite leitende Platte (35, 45) auf der zweiten Isolationsschicht gebildet wird.

4. Verfharen nach Anspruch 3, dadurch gekennzeichnet, daß die zweite leitende Platte (45) gebildet wird, so daß sie eine kleinere Fläche als die erste leitende Platte (43) hat.

5. Integrierte Filterschaltung in einem Halbleiterkörper, enthaltend einen Operationsverstärker, einen Kondensator und einen Widerstand, wobei der Widerstand als leicht dotierter Bereich (36, 37; 46, 47) im Halbleiterkörper (31; 41) gebildet ist und der Kondensator durch eine erste leitende Platte (33; 43) und eine zweite leitende Platte (35; 45) gebildet ist, wobei die erste leitende Platte oberhalb des Widerstandes und von diesem isoliert gebildet ist, so daß, wenn eine feste Spannung mit der ersten leitenden Platte gekoppelt ist, die Platte den darunter liegenden Widerstand abschirmt, dadurch gekennzeichnet, daß die zweite leitende Platte oberhalb von der ersten leitenden Platte gebildet und von dieser isoliert ist.

6. Filter nach Anspruch 5, dadurch gekennzeichnet, daß die erste leitende Platte (43) eine Fläche größer als die Fläche der zweiten leitenden Platte (45) hat.

## EP 0 165 766 B1

### Revendications

1. Structure semi-conductrice (30; 40) comprenant un substrat (31; 41) d'un premier type de conductivité, une résistance (36, 37; 46, 47) formée à l'intérieur du substrat, la résistance étant légèrement dopée à un second type de conductivité opposé au premier type de conductivité et une première plaque conductrice (33; 43) formée au-dessus et isolée de la résistance, la première plaque conductrice étant destinée à être couplée à une tension fixe pour protéger la résistance sous-jacente, caractérisée par une seconde plaque conductrice (35; 45) formée au-dessus et isolée de la première plaque conductrice, les première et seconde plaques conductrices formant un condensateur.

2. Structure selon la revendication 1, caractérisée en ce que la première plaque conductrice (43) est d'une plus grande étendue que ladite seconde plaque conductrice (45).

3. Procédé pour former une structure semi-conductrice (30; 40), comprenant les étapes qui consistent à former, à l'intérieur d'un substrat semi-conducteur (31; 41) d'un premier type de conductivité, une résistance (36, 37; 46, 47) qui est légèrement dopée à un second type de conductivité opposé au premier type de conductivité, à former une première couche isolante (32; 42) sur le substrat semi-conducteur et à former une première plaque conductrice (33; 43) sur la première couche isolante, au-dessus de la résistance, la première plaque conductrice étant destinée à être couplée à une tension fixe pour protéger la résistance sous-jacente, caractérisé en ce qu'il comprend les étapes qui consistent à former une seconde couche isolante (34; 44) sur la première plaque conductrice et à former une seconde plaque conductrice (35; 45) sur la seconde couche isolante.

4. Procédé selon la revendication 3, caractérisé en ce que la seconde plaque conductrice (45) est formée de façon à avoir une étendue inférieure à celle de la première plaque conductrice (43).

5. Filtre à circuit intégré dans un corps semi-conducteur comprenant un amplificateur opérationnel, un condensateur et une résistance, la résistance étant formée comme étant une région légèrement dopée (36, 37; 46, 47) à l'intérieur du corps semi-conducteur (31; 41), et le condensateur étant formé par une première plaque conductrice (33; 43) et une seconde plaque conductrice (35; 45), la première plaque conductrice étant formée au-dessus et isolée de la résistance de manière que, lorsqu'une tension fixe est couplée à la première plaque conductrice, la plaque protège la résistance sous-jacente, caractérisé en ce que la seconde plaque conductrice est formée au-dessus et isolée de la première plaque conductrice.

6. Filtre selon la revendication 5, caractérisé en ce que la première plaque conductrice (43) est d'une étendue plus grande que l'étendue de la seconde plaque conductrice (45).

7

antialaising filter
transfer
function

125KHZ 128KHZ 131KHZ

3KHZ

0

FIG. 1

1

FIG. 2

FIG. 3a

FIG. 3b

EP 0 165 766 B1